# EUROPEAN PATENT APPLICATION

(11) **EP 4 518 605 A1**
(43) Date of publication of application: **05.03.2025**
(21) Application number: 24777647.9
(22) Date of filing: 05.03.2024
(51) Int. Cl.: H10B 12/00, H01L 29/78, H01L 21/762, H01L 21/764

(54) **TRANSISTOR STRUCTURE, SEMICONDUCTOR STRUCTURE, AND PREPARATION METHOD THEREFOR**

(30) Priority: 29.03.2023 CN 202310318809
(71) Applicant: CXMT Corporation, Hefei City, Anhui Province 230601 (CN)
(72) Inventor: LIU, Xiang, Hefei, Anhui 230601 (CN)
(74) Representative: Gulde & Partner
(86) International application number: PCT/CN2024/080124
(87) International publication number: WO 2024/198857

(57) **Abstract**

Disclosed are a transistor structure, and a semiconductor structure and manufacturing method therefor. The semiconductor structure includes a substrate and a word line structure. The substrate is provided with a plurality of active groups that are spaced apart and arranged in an array along a first direction and a second direction. Each active group includes two semiconductor pillars that are opposite to each other in the second direction and separated by a separation trench. The word line structure includes one first word line and two second word lines, which are disposed corresponding to any one column of the active groups arranged along the first direction. The first word line is located within the separation trench, and the two second word lines are respectively located on sidewalls, facing away from the separation trench, of corresponding semiconductor pillars. Both the second word line and the first word line extend along the first direction, and the second word line and the first word line are offset in a direction perpendicular to the substrate.

## Description

### CROSS-REFERENCE TO RELATED APPLICATIONS

The present disclosure claims priority to Chinese Patent Application No. 202310318809.8, titled "TRANSISTOR STRUCTURE, AND SEMICONDUCTOR STRUCTURE AND MANUFACTURING METHOD THEREFOR" and filed on March 29, 2023, the entire content of which is incorporated herein by reference in its entirety.

### TECHNICAL FIELD

The present disclosure relates to the field of semiconductor technologies, in particular to a transistor structure, and a semiconductor structure and manufacturing method therefor.

### BACKGROUND

With the advancement of dynamic random access memory (DRAM) technology, the size of memory cells has been continuously decreasing. The array architecture has evolved from 8F² to 6F², and then to 4F² (where F represents the smallest feature size achievable under a given process condition). Additionally, to minimize the area occupied by transistors in an individual array area as much as possible and to achieve higher chip area utilization, vertical channel array transistor (VCAT) technology has been developed.

However, in the 4F² design structure, parasitic capacitance forms between two adjacent word lines; therefore, the moment the voltage of one of the word line rises, the voltage of the other one of the word line also rises rapidly, resulting in significant leakage current. Therefore, how to prevent interference between two adjacent word lines to reduce static leakage during the use of the device is a pressing issue that needs to be addressed.

### SUMMARY

Based on this, the present disclosure provides a transistor structure, and a semiconductor structure and manufacturing method therefor, which can avoid interference between two adjacent word lines, thereby reducing static leakage during the use of the device.

To achieve the above objective, the present disclosure, in one aspect, provides a semiconductor structure. The semiconductor structure includes:
a substrate, provided with a plurality of active groups that are spaced apart and arranged in an array along a first direction and a second direction, wherein each active group includes two semiconductor pillars that are opposite to each other in the second direction and separated by a separation trench; the second direction intersects with the first direction; and
a word line structure, the word line structure including one first word line and two second word lines, which are disposed corresponding to any one column of the active groups arranged along the first direction, wherein the first word line is located within the separation trench, and the two second word lines are respectively located on sidewalls, facing away from the separation trench, of corresponding semiconductor pillars,
wherein both the second word line and the first word line extend along the first direction, and the second word line and the first word line are offset in a direction perpendicular to the substrate.

In some embodiments, the semiconductor structure further includes:
an air gap structure, located within the separation trench and above the first word line, the air gap structure being opposite to the second word line in the second direction.

In some embodiments, a top surface of the first word line is flush with a bottom surface of the second word line or lower than the bottom surface of the second word line.

In some embodiments, a bottom surface of the second word line is flush with a bottom surface of the air gap structure or higher than the bottom surface of the air gap structure; a top surface of the second word line is flush with a top surface of the air gap structure or lower than the top surface of the air gap structure.

In some embodiments, the semiconductor structure further includes:
an interlayer dielectric layer, covering sidewalls, perpendicular to the second direction, of the two semiconductor pillars and located between the two semiconductor pillars and the first word line as well as between the two semiconductor pillars and the two second word lines.

In some embodiments, the semiconductor structure further includes:
a first isolation structure, located within the separation trench and enclosing the air gap structure, wherein the first isolation structure is used to define a top surface of the air gap structure; and
a second isolation structure, located within a gap between adjacent active groups and covering the second word line and the interlayer dielectric layer within the gap.

In some embodiments, the semiconductor structure further includes:
a plurality of capacitor units, respectively disposed above corresponding semiconductor pillars.

In another aspect, the present disclosure further provides a method for manufacturing a semiconductor structure. The method for manufacturing a semiconductor structure includes:
providing a substrate;
forming a plurality of parallel separation trenches that are spaced apart and extend along a first direction within the substrate to obtain a plurality of intermediate structures;
forming a first word line within the separation trench;
patterning the intermediate structures to obtain a plurality of active groups arranged in an array along the first direction and a second direction, wherein each active group includes two semiconductor pillars that are opposite to each other in the second direction and separated by the separation trench; the second direction intersects with the first direction; and
forming second word lines on sidewalls, facing away from the plurality of separation trenches, of semiconductor pillars,
wherein both the second word line and the first word line extend along the first direction, and the second word line and the first word line are offset in a direction perpendicular to the substrate.

In some embodiments, before patterning the intermediate structures, the method further includes:
forming a first isolation structure within the separation trench, wherein the first isolation structure is used to define a top surface of an air gap structure, and the air gap structure is located above the first word line within the separation trench,
wherein the second word lines are opposite to the air gap structure in the second direction.

In some embodiments, before forming the first word line within the separation trench, the method further includes: forming a first interlayer dielectric layer covering an inner wall of the separation trench, wherein the first word line is formed on the first interlayer dielectric layer and fills a portion of the separation trench; and
before forming the first isolation structure within the separation trench, the method further includes: forming a second interlayer dielectric layer covering at least a top surface of the first word line, wherein the air gap structure is formed on the second interlayer dielectric layer.

In some embodiments, forming the plurality of parallel separation trenches that are spaced apart and extend along the first direction within the substrate to obtain the plurality of intermediate structures includes:
patterning the substrate to form a plurality of parallel initial structures that are spaced apart and extend along the second direction;
forming a first sub-isolation structure in a gap between adjacent initial structures; and
forming the plurality of separation trenches along the first direction within the plurality of initial structures and the first sub-isolation structures to obtain the intermediate structures.

In some embodiments, after patterning the intermediate structures and before forming the second word lines on the sidewalls, facing away from the plurality of separation trenches, of the semiconductor pillars, the method further includes:
forming an initial second sub-isolation structure in a gap between adjacent active groups in the second direction; and
etching back the initial second sub-isolation structure to form a word line trench and obtain a second sub-isolation structure; and
forming the second word lines on the sidewalls, facing away from the plurality of separation trenches, of the semiconductor pillars includes:
conformally forming a third interlayer dielectric layer on an inner wall of the word line trench;
forming the second word lines on sidewalls, facing away from semiconductor pillars on both sides, of the third interlayer dielectric layer, respectively, wherein there is a space between two second word lines within the same word line trench; and
forming a third sub-isolation structure covering exposed surfaces of the second sub-isolation structure, the second word line, and the third interlayer dielectric layer within the word line trench, wherein the third sub-isolation structure, along with the second sub-isolation structure and the first sub-isolation structure, jointly form a second isolation structure.

In some embodiments, a bottom surface of the word line trench is flush with a top surface of the first word line;
or, the bottom surface of the word line trench is lower than the top surface of the first word line.

In some embodiments, a bottom surface of the second word line is flush with a bottom surface of the air gap structure or higher than the bottom surface of the air gap structure; a top surface of the second word line is flush with a top surface of the air gap structure or lower than the top surface of the air gap structure.

In some embodiments, the method further includes:
forming a capacitor unit above the semiconductor pillar.

The semiconductor structure and manufacturing method therefor provided in the present disclosure can have at least the following beneficial effects.

In the embodiments of the present disclosure, the separation trench can separate the same active group into two semiconductor pillars, with two second word lines formed on the outer sidewalls of the two semiconductor pillars, respectively, and a first word line formed within the separation trench. Based on this, the second word lines and the first word line are offset in the direction perpendicular to the substrate, allowing the second word lines and the first word line to jointly form a control word line for the corresponding semiconductor pillars. Such an arrangement can reduce the interference between the two second word lines of adjacent active groups, thereby reducing the static leakage during the use of the device.

In yet another aspect, the present disclosure further provides a transistor structure. The transistor structure includes: a semiconductor pillar as well as a first gate and a second gate located on opposite sides of the semiconductor pillar, respectively,
wherein the first gate and the second gate are offset in an extending direction of the semiconductor pillar; the first gate and the second gate jointly form a control gate of the semiconductor pillar.

In some embodiments, a top surface of the first gate is flush with a bottom surface of the second gate or lower than the bottom surface of the second gate.

In some embodiments, the transistor structure further includes: an air gap structure located between two adjacent semiconductor pillars and above the first gate, with bottoms of the two adjacent semiconductor pillars interconnected.

The transistor structure provided in the present disclosure can have at least the following beneficial effects.

In the embodiments of the present disclosure, the first gate and the second gate are offset in the direction perpendicular to the substrate to jointly control the semiconductor pillar, such that interference between adjacent transistors can be reduced, thereby reducing static leakage during the use of the device.

### BRIEF DESCRIPTION OF THE DRAWINGS

To more clearly illustrate the technical solutions in the embodiments of the present disclosure or the conventional technology, a brief introduction to the drawings required for the description of the embodiments or conventional technology is given hereinafter. It is evident that the drawings described hereinafter are merely some embodiments of the present disclosure. For those of ordinary skill in the art, other drawings may also be obtained based on these drawings without creative effort.
FIG. 1(a) is a schematic cross-sectional view of a semiconductor structure according to some embodiments of the present disclosure; FIG. 1(b) is a partial schematic view of the structure shown in FIG. 1(a);
FIG. 2(a) is a partial schematic view of a semiconductor structure when writing 0 according to some embodiments of the present disclosure; FIG. 2(b) is a voltage-current diagram of the structure shown in FIG. 2(a) when writing 0;
FIG. 3(a) is a partial schematic view of a semiconductor structure when writing 1 according to some embodiments of the present disclosure; FIG. 3(b) is a voltage-current diagram of the structure shown in FIG. 3(a) when writing 1;
FIG. 4 is a schematic flowchart of a method for manufacturing a semiconductor structure according to some embodiments of the present disclosure;
FIG. 5 is a schematic flowchart of step S200 in a method for manufacturing a semiconductor structure according to some embodiments of the present disclosure;
FIG. 6 is a schematic flowchart of step S500 in a method for manufacturing a semiconductor structure according to some embodiments of the present disclosure;
FIG. 7 is a schematic cross-sectional view of a structure obtained in step S100 in a method for manufacturing a semiconductor structure according to some embodiments of the present disclosure;
FIG. 8(a) is a schematic cross-sectional view of a structure obtained in step S210 in a method for manufacturing a semiconductor structure according to some embodiments of the present disclosure; FIG. 8(b) is a schematic top view of FIG. 8(a);
FIG. 9(a) is a schematic cross-sectional view of a structure obtained in step S220 in a method for manufacturing a semiconductor structure according to some embodiments of the present disclosure; FIG. 9(b) is a schematic top view of FIG. 9(a);
FIG. 10 is a schematic view of a process structure of step S220 in a method for manufacturing a semiconductor structure according to some embodiments of the present disclosure;
FIG. 11 is a schematic cross-sectional view of a structure obtained after forming a first interlayer dielectric layer in a method for manufacturing a semiconductor structure according to some embodiments of the present disclosure;
FIG. 12 is a schematic cross-sectional view of a structure obtained in step S300 in a method for manufacturing a semiconductor structure according to some embodiments of the present disclosure;
FIG. 13 is a schematic cross-sectional view of a structure obtained in step S400 in a method for manufacturing a semiconductor structure according to some embodiments of the present disclosure;
FIG. 14 is a schematic cross-sectional view of a structure obtained after forming an initial second sub-isolation structure in a method for manufacturing a semiconductor structure according to some embodiments of the present disclosure;
FIG. 15 is a schematic cross-sectional view of a structure obtained after obtaining a second sub-isolation structure in a method for manufacturing a semiconductor structure according to some embodiments of the present disclosure;
FIG. 16 is a schematic cross-sectional view of a structure obtained in step S510 in a method for manufacturing a semiconductor structure according to some embodiments of the present disclosure;
FIG. 17 is a schematic cross-sectional view of a structure obtained in step S520 in a method for manufacturing a semiconductor structure according to some embodiments of the present disclosure;
FIG. 18 is a schematic cross-sectional view of a structure obtained in step S530 in a method for manufacturing a semiconductor structure according to some embodiments of the present disclosure;
FIG. 19 is a partial, enlarged schematic view of a structure obtained in step S530 in a method for manufacturing a semiconductor structure according to some embodiments of the present disclosure;
FIG. 20 is a schematic cross-sectional view of a transistor structure according to some embodiments of the present disclosure; and
FIG. 21 is a schematic cross-sectional view of a transistor structure according to other embodiments of the present disclosure.

Reference numerals in the figures are as follows:
1: Substrate; 100: Semiconductor pillar; 10a: Intermediate structure; 10b: Initial structure; 10c: First sub-isolation structure; 11a: Patterned mask layer; 111a: Mask pattern; 112a: Mask sidewall; 2: Word line structure; 21: First word line; 22: Second word line; 3: Air gap structure; 4: Interlayer dielectric layer; 41: First interlayer dielectric layer; 42: Second interlayer dielectric layer; 43: Third interlayer dielectric layer; 5: First isolation structure; 6: Second isolation structure; 61a: Initial second sub-isolation structure; 61: Second sub-isolation structure; 62: Third sub-isolation structure; 7: Capacitor contact structure;
S: Separation trench; W: Word line trench; G1: First gate; G2: Second gate; G21: Second gate on the right side; G22: Second gate on the left side.

### DETAILED DESCRIPTION

To facilitate understanding of the present disclosure, a more comprehensive description of the present disclosure will be provided hereinafter with reference to the relevant drawings. The drawings illustrate the preferred embodiments of the present disclosure. However, the present disclosure can be implemented in many different forms and is not limited to the embodiments described herein. Rather, these embodiments are provided to make the disclosed contents more thorough and comprehensive.

Unless otherwise defined, all technical and scientific terms used herein have the same meaning as commonly understood by those skilled in the art to which the present disclosure belongs. The terms used in the specification of the present disclosure are for the purpose of describing particular embodiments only and are not intended to limit the present disclosure.

It should be understood that when an element or layer is referred to as being "on" or "adjacent to" another element or layer, it may be directly on or adjacent to the other element or layer, or an intervening element or layer may be present. It should be understood that although the terms first, second, third, etc. may be used to describe various elements, components, regions, layers, word lines, and/or portions, these elements, components, regions, layers, word lines, and/or portions should not be limited by these terms. These terms are only used to distinguish one element, component, region, layer, word line, or portion from another element, component, region, layer, word line, or portion. Thus, a first element, component, region, layer, word line, or portion discussed hereinafter may be termed a second element, component, region, layer, word line, or portion without departing from the teachings of the present disclosure; for example, a first word line may be referred to as a second word line, and similarly, a second word line may be referred to as a first word line; the first word line is different from the second word line.

Spatial relationship terms such as "on", "above", etc., may be used herein to describe the relationship of one element or feature to another element or feature as illustrated in the figures. It should be understood that the spatial relationship terms include different orientations of the device in use or operation in addition to the orientation illustrated in the figures. For example, if the device in the figures is turned over, an element or feature described as "above" or "on top of" another element or feature would be oriented "below" the another element or feature. Thus, the exemplary terms "on" and "above" can encompass both upward and downward orientations. In addition, the device may include additional orientations (e.g., rotated 90 degrees or at other orientations), and the spatial descriptive terms used herein should be interpreted accordingly.

As used herein, the singular forms "a", "an", and "the" may include the plural forms as well, unless the context clearly indicates otherwise. It should also be understood that the terms "comprise" and/or "include" when used in the specification, specify the presence of stated features, integers, steps, operations, elements, and/or components, but do not preclude the presence or addition of one or more other features, integers, steps, operations, elements, components, and/or groups. Additionally, as used herein, the term "and/or" includes any and all combinations of the associated listed items.

The embodiments of the invention are described here with reference to the schematic cross-sectional views of the ideal embodiments (and intermediate structures) of the present disclosure, such that variations in the shapes shown are to be expected, for example, due to manufacturing techniques and/or tolerances. The embodiments of the present disclosure should not be limited to the specific shapes of regions shown herein but should include shape deviations resulting from manufacturing techniques, for example. Therefore, the regions shown in the figures are essentially illustrative, and their shapes do not represent the actual shapes of the regions of the device, nor do they limit the scope of the present disclosure.

In view of the shortcomings in the prior art, the present disclosure provides a transistor structure, and a semiconductor structure and manufacturing method therefor, which can avoid interference between two adjacent word lines, thereby reducing static leakage during the use of the device.

The present disclosure, according to some embodiments, provides a semiconductor structure.

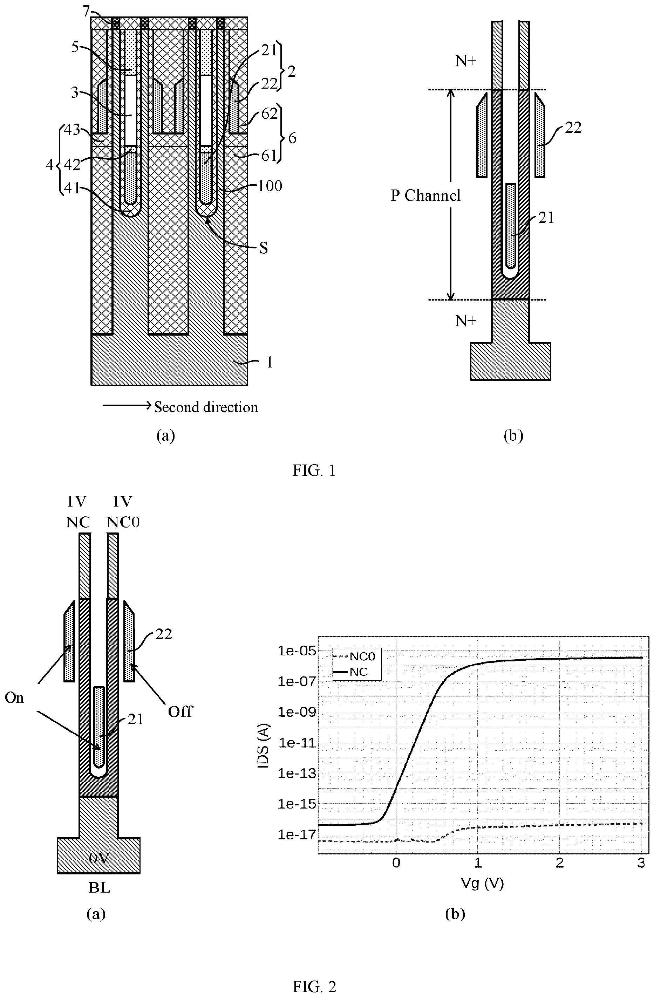

Refer to FIG. 1(a) and FIG. 1(b). In some embodiments, the semiconductor structure may include a substrate 1 and a word line structure 2.

The substrate 1 is provided with a plurality of active groups that are spaced apart and arranged in an array along a first direction and a second direction. Each active group includes two semiconductor pillars 100 that are opposite to each other in the second direction and separated by a separation trench S.

The word line structure 2 includes one first word line 21 and two second word lines 22, which are disposed corresponding to any one column of the active groups arranged along the first direction. The first word line 21 is located within the separation trench S, and the two second word lines 22 are respectively located on the sidewalls, facing away from the separation trench S, of the corresponding semiconductor pillars 100. Both the second word line 22 and the first word line 21 extend along the first direction, and the second word line 22 and the first word line 21 are offset in a direction perpendicular to the substrate 1. For example, the bottom surface of the second word line 22 is flush with or higher than the top surface of the first word line 21, and the distance between the bottom surface of the second word line 22 and the top surface of the first word line 21 is less than 30 nm. Due to the divergence range of the electric field formed by the first word line 21 and the second word line 22, the fact that the bottom surface of the second word line 22 is higher than the top surface of the first word line 21 but within a distance of less than 30 nm will not affect the turn-on of the transistor.

In the semiconductor structure provided in the above embodiments, the separation trench S can separate the same active group into two semiconductor pillars 100, with two second word lines 22 formed on the outer sidewalls of the two semiconductor pillars 100, respectively, and the first word line 21 formed within the separation trench S. Based on this, the second word lines 22 and the first word line 21 are offset in the direction perpendicular to the substrate 1, allowing the second word lines 22 and the first word line 21 to jointly form a control word line for the corresponding semiconductor pillars 100. That is, merely turning on the first word line 21 or the second word line 22 alone is not sufficient to turn on the corresponding transistor device. Such an arrangement can reduce the interference between the two second word lines 22 of adjacent active groups, thereby reducing the static leakage during the use of the device.

In addition, the semiconductor structure provided in the above embodiments reduces the interference between two second word lines 22 of adjacent active groups and can also lower the parasitic capacitance between adjacent second word lines 22, thereby reducing the impact of the parasitic capacitance on the charging and discharging speed of the device, and thus improving the storage speed of the semiconductor structure.

Moreover, within the same active group, the two second word lines 22 respectively disposed on the outer sidewalls of the two semiconductor pillars 100 share the same first word line 21. This can, on one hand, minimize the size of the semiconductor structure to the greatest extent, and on the other hand, make the layout of the semiconductor structure more reasonable, thereby effectively enhancing the storage density of the semiconductor structure.

It should be noted that, in the embodiments of the present disclosure, the second direction intersects with the first direction.

Refer to FIG. 1(a) to understand the role of the first word line 21 and the second word line 22 during operation in improving the coupling of adjacent transistors: For two adjacent active groups, when the first word line 21 in the left active group and the second word line 22 on the right side are turned on, the surrounding electrons will gather in the channel on the right side of the left active group. Since the second word line 22 on the right side of the left active group is adjacent to the second word line 22 on the left side of the right active group, this may cause the voltage of the second word line 22 on the left side of the right active group to rise, leading to electrons gathering in the channel corresponding to the second word line 22 in the right active group. However, since the first word line 21 in the right active group is not turned on, it can prevent the leakage of electrons gathered in the channel of the right active group. Moreover, without changing the channel length within the semiconductor structure, providing a shorter second word line 22 reduces the parasitic capacitance between adjacent second word lines 22 in adjacent active groups.

In addition, refer to FIG. 1(b) to understand the role of the first word line 21 at the bottom of the separation trench S in improving the static leakage of the device during use:

Taking the device on the right side as an example, the bottom and the top of the active group are of a first doping type, and the middle of the active group is of a second doping type. For example, the bottom and the top of the active group are N+ type doping and used as source and drain, and the middle of the active group is P type doping and used as a P-type channel (P channel). When the first word line 21 at the bottom is turned on, due to its higher voltage (e.g., 2 V to 3 V), which is greater than the operating voltage (e.g., 1 V) of the bit line or storage structure (e.g., a capacitor unit in electrical contact with the top surface of the semiconductor pillar, not shown in the figure), surrounding electrons will gather around the first word line 21 at the bottom and will not continuously leak between the storage structure and the bit line.

The present disclosure does not specifically limit the material of the substrate 1. As an example, the substrate 1 may include a silicon (Si) substrate, a silicon-germanium (SiGe) substrate, a silicon-germanium-carbon (SiGeC) substrate, a silicon carbide (SiC) substrate, a gallium arsenide (GaAs) substrate, an indium arsenide (InAs) substrate, an indium phosphide (InP) substrate, or other III/V semiconductor substrates 100 or II/VI semiconductor substrates 100; alternatively, the substrate 1 may also include Si/SiGe, Si/SiC, silicon-on-insulator (SOI), silicon-germanium-on-insulator substrates, or other substrates.

The present disclosure does not specifically limit the material of the word line structure 2. As an example, the material of the word line structure 2 may include, but is not limited to, metal materials such as tungsten, cobalt, and titanium nitride.

Continue to refer to FIG. 1(a). In some embodiments, the semiconductor structure may further include an air gap structure 3. The air gap structure 3 is located within the separation trench S and above the first word line 21. The air gap structure is opposite to the second word line 22 in the second direction.

In the semiconductor structure provided in the above embodiments, the air gap structure 3 within the separation trench S can reduce the floating body effect between adjacent active groups, thereby further reducing the static leakage of the device during use.

The present disclosure does not specifically limit the positional relationship between the first word line 21 and the second word line 22. As an example, the top surface of the first word line 21 may be flush with the bottom surface of the second word line 22; alternatively, the top surface of the first word line 21 may be lower than the bottom surface of the second word line 22.

The present disclosure does not specifically limit the positional relationship between the second word line 22 and the air gap structure 3 either. As an example, the bottom surface of the second word line 22 may be flush with the bottom surface of the air gap structure 3; alternatively, the bottom surface of the second word line 22 may be higher than the bottom surface of the air gap structure 3. As an example, the top surface of the second word line 22 may be flush with the top surface of the air gap structure 3; alternatively, the top surface of the second word line 22 may be lower than the top surface of the air gap structure 3.

Continue to refer to FIG. 1(a). In some embodiments, the semiconductor structure may further include an interlayer dielectric layer 4. The interlayer dielectric layer 4 covers the sidewalls of the semiconductor pillar 100 that are perpendicular to the second direction and is located between the semiconductor pillar 100 and the first word line 21 as well as between the semiconductor pillar 100 and the second word line 22.

It should be noted that, in other embodiments, the interlayer dielectric layer 4 may not be disposed between the air gap structure 3 and the semiconductor pillar 100, which is also permissible. For example, the orthographic projection of the interlayer dielectric layer 4 on the semiconductor pillar 100 may overlap or substantially overlap with the orthographic projection of the first word line 21 on the semiconductor pillar 100, and overlap or substantially overlap with the orthographic projection of the second word line 22 on the semiconductor pillar 100.

Continue to refer to FIG. 1(a). In some embodiments, the semiconductor structure may further include a first isolation structure 5 and a second isolation structure 6.

The first isolation structure 5 is located within the separation trench S and encloses the air gap structure 3. The first isolation structure 5 can be used to define the top surface of the air gap structure 3. The second isolation structure 6 is located within the gap between adjacent active groups and covers the second word line 22 and the interlayer dielectric layer 4 within the gap.

The present disclosure does not specifically limit the material of the first isolation structure 5. As an example, the material of the first isolation structure 5 may include, but is not limited to, silicon nitride (SiN), silicon oxynitride (SiON), silicon oxide (SiO₂), etc., or combinations thereof.

In some embodiments, the semiconductor structure may further include a plurality of capacitor units.

For example, the plurality of capacitor units (not shown in the figure) may be respectively disposed above the corresponding semiconductor pillars 100.

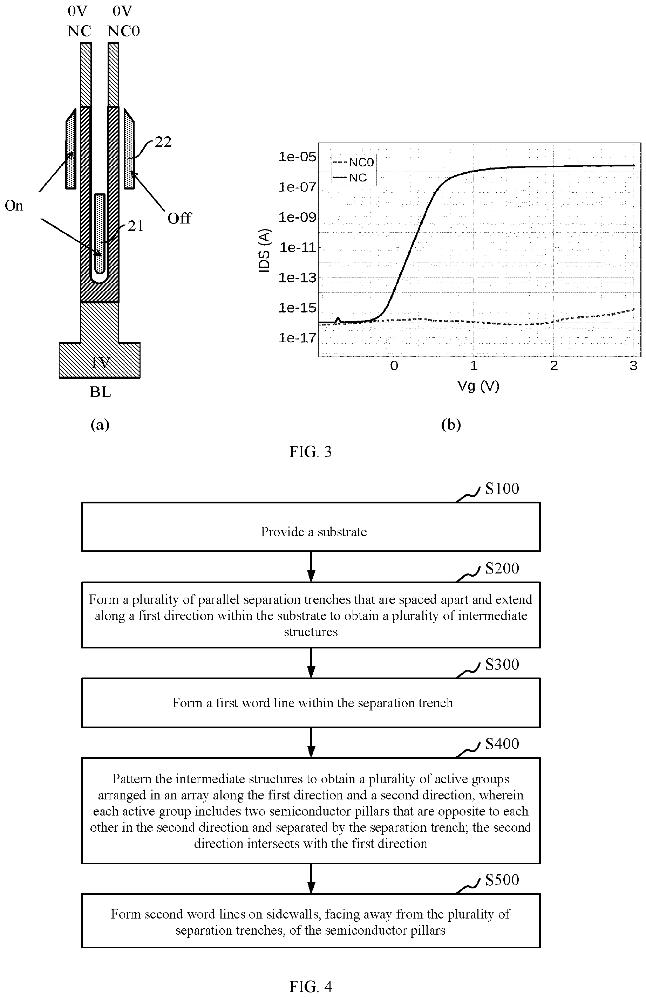

FIGS. 2(a) and 2(b) illustrate the drain-to-source current IDS flowing through two capacitor units when writing 0 (e.g., 0 V). FIGS. 3(a) and 3(b) illustrate the drain-to-source current IDS flowing through the storage nodes NC and NC0 corresponding to the two capacitor units when writing 1 (e.g., 1 V). Vg refers to the voltage applied to the storage node, and IDS refers to the current flowing through the storage node.

As shown in FIGS. 2(a) and 2(b), when writing 0, if the left-side second word line 22 and the bottom first word line 21 are turned on (On), while the right-side second word line 22 remains off (Off), the left-side device is turned on, current flows through the corresponding storage node NC, while almost no current flows through the other-side storage node NC0. That is, the right-side device can remain in an off state.

As shown in FIGS. 3(a) and 3(b), when writing 1, if the left-side second word line 22 and the bottom first word line 21 are turned on, while the right-side second word line 22 remains off, the left-side device is turned on, current flows through the corresponding storage node NC, while almost no current flows through the other-side storage node NC0. That is, the right-side device can remain in an off state.

As an example, as shown in FIG. 1(a), a capacitor contact structure 7 may be aligned and disposed on the semiconductor pillar 100. The material of the capacitor contact structure 7 may be polysilicon, metal, or metal silicide, among others. This is advantageous for improving the contact between the capacitor unit and the corresponding semiconductor pillar 100.

The present disclosure, according to some embodiments, further provides a method for manufacturing a semiconductor structure.

Refer to FIG. 4. In some embodiments, the method for manufacturing a semiconductor structure may include the following steps.

In S100, a substrate is provided.

In S200, a plurality of parallel separation trenches that are spaced apart and extend along a first direction are formed within the substrate to obtain a plurality of intermediate structures.

In S300, a first word line is formed within the separation trench.

In S400, the intermediate structures are patterned to obtain a plurality of active groups arranged in an array along the first direction and a second direction, where each active group includes two semiconductor pillars that are opposite to each other in the second direction and separated by a separation trench; the second direction intersects with the first direction.

In S500, second word lines are formed on the sidewalls, facing away from the separation trenches, of the semiconductor pillars.

It should be noted that both the second word line and the first word line extend along the first direction, and the second word line and the first word line are offset in a direction perpendicular to the substrate. For example, the bottom surface of the second word line is flush with or higher than the top surface of the first word line, and the distance between the bottom surface of the second word line and the top surface of the first word line is less than 30 nm.

In the method for manufacturing a semiconductor structure provided in the above embodiments, the separation trench S can separate the same active group into two semiconductor pillars 100, with two second word lines 22 formed on the outer sidewalls of the two semiconductor pillars 100, respectively, and the first word line 21 formed within the separation trench S. Based on this, the second word lines 22 and the first word line 21 are offset in the direction perpendicular to the substrate 1, allowing the second word lines 22 and the first word line 21 to jointly form a control word line for the corresponding semiconductor pillars 100. That is, merely turning on the first word line 21 or the second word line 22 alone is not sufficient to turn on the corresponding device. Such an arrangement can reduce the interference between the two second word lines 22 of adjacent active groups, thereby reducing the static leakage during the use of the device.

In addition, the method for manufacturing a semiconductor structure provided in the above embodiments reduces the interference between two second word lines 22 of adjacent active groups and can also lower the parasitic capacitance between adjacent second word lines 22, thereby reducing the impact of the parasitic capacitance on the charging and discharging speed of the device, and thus improving the storage speed of the semiconductor structure.

Moreover, within the same active group, the two second word lines 22 respectively formed on the outer sidewalls of the two semiconductor pillars 100 share the same first word line 21. This can, on one hand, minimize the size of the semiconductor structure to the greatest extent, and on the other hand, make the layout of the semiconductor structure more reasonable, thereby effectively enhancing the storage density of the semiconductor structure.

In some embodiments, before patterning the intermediate structures, the manufacturing method may further include the following step: forming a first isolation structure within the separation trench.

The first isolation structure is used to define the top surface of the air gap structure, and the air gap structure is located above the first word line within the separation trench. It should be noted that the second word lines are opposite to the air gap structure in the second direction.

In the method for manufacturing a semiconductor structure provided in the above embodiments, the air gap structure 3 within the separation trench S can reduce the floating body effect between adjacent active groups, thereby further reducing the static leakage of the device during use.

In some embodiments, before forming the first word line within the separation trench, the manufacturing method may further include the following step: forming a first interlayer dielectric layer covering the inner wall of the separation trench.

It should be noted that the first word line is formed on the first interlayer dielectric layer and fills a portion of the separation trench.

In some embodiments, before forming the first isolation structure within the separation trench, the manufacturing method may further include the following step: forming a second interlayer dielectric layer covering at least the top surface of the first word line.

It should be noted that the air gap structure is formed on the second interlayer dielectric layer.

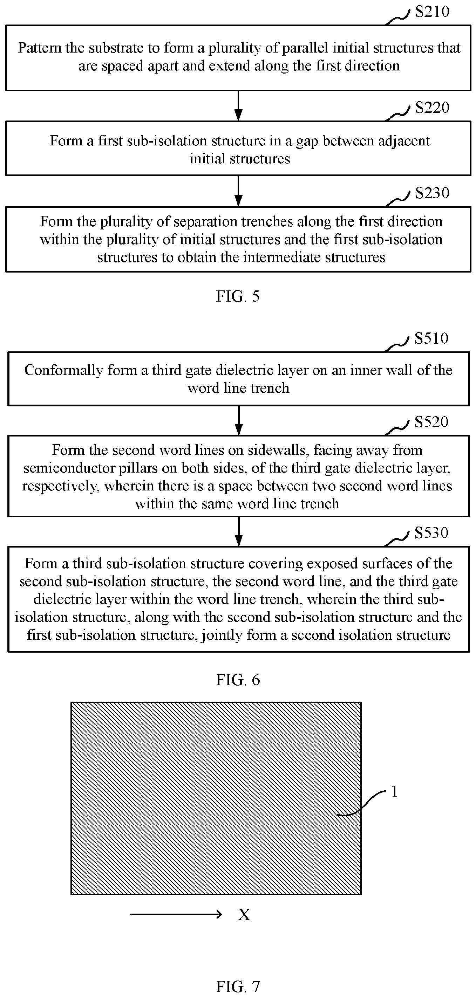

Refer to FIG. 5. In some embodiments, forming the plurality of parallel separation trenches that are spaced apart and extend along the first direction within the substrate to obtain the plurality of intermediate structures may include the following steps:

In S210, the substrate is patterned to form a plurality of parallel initial structures that are spaced apart and extend along a second direction.

In S220: a first sub-isolation structure is formed in the gap between adjacent initial structures.

In S230: a plurality of separation trenches along the first direction are formed within the plurality of initial structures and the first sub-isolation structures to obtain the intermediate structures.

In some embodiments, after patterning the intermediate structures and before forming the second word line on the sidewall, facing away from the separation trench, of the semiconductor pillar, the manufacturing method may further include the following steps: forming an initial second sub-isolation structure in the gap between adjacent active groups in the second direction; and etching back the initial second sub-isolation structure to form a word line trench and obtain a second sub-isolation structure.

Refer to FIG. 6. In some embodiments, forming the second word lines on the sidewalls, facing away from the separation trenches, of the semiconductor pillars in step S500 may include the following steps.

In S510, a third interlayer dielectric layer is conformally formed on the inner wall of the word line trench.

In S520, second word lines are formed on the sidewalls, facing away from the semiconductor pillars on both sides, of the third interlayer dielectric layer, respectively; there is a space between the two second word lines within the same word line trench.

In S530, a third sub-isolation structure covering the exposed surfaces of the second sub-isolation structure, the second word line, and the third interlayer dielectric layer is formed within the word line trench; the third sub-isolation structure, along with the second sub-isolation structure and the first sub-isolation structure, jointly form a second isolation structure.

In some embodiments, the manufacturing method may further include the following step: forming a capacitor unit above the semiconductor pillar.

It should be understood that although the steps in the flowcharts of FIGS. 4 to 6 are shown sequentially according to the arrows, these steps are not necessarily executed in the order indicated by the arrows. Unless explicitly stated herein otherwise, there is no strict order limitation on the execution of these steps, and they may be executed in other sequences. Moreover, at least a portion of the steps in FIGS. 4 to 6 may include a plurality of steps or a plurality of stages, and these steps or stages are not necessarily executed or completed at the same time but may be executed at different times. These steps or stages are not necessarily executed in a sequential order but may be executed alternately or in rotation with at least a portion of other steps, or steps or stages from other steps.

To more clearly illustrate the manufacturing methods in the above embodiments, refer to FIGS. 7 to 19 for understanding some embodiments of the present disclosure.

Refer to FIG. 7. In step S100, a substrate 1 is provided.

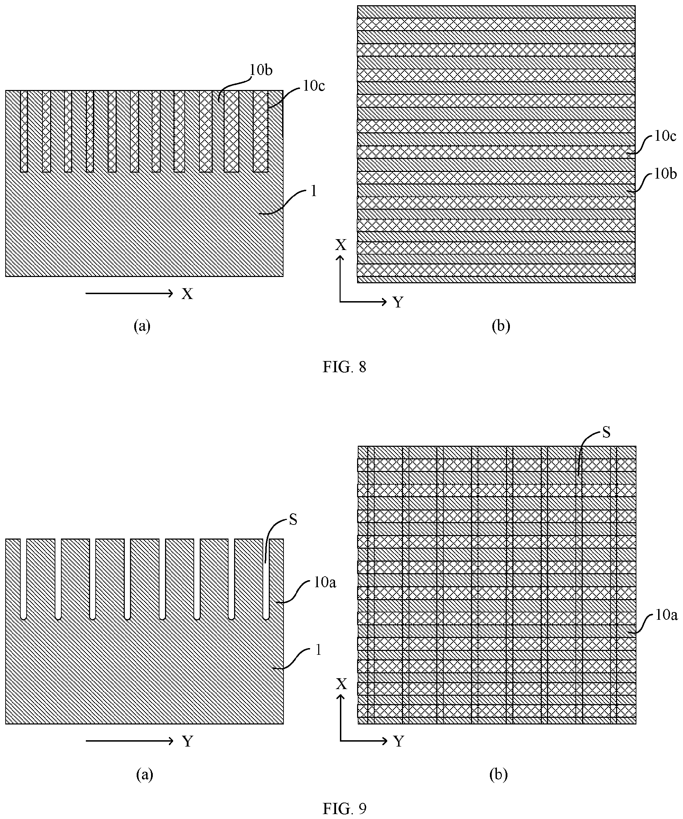

Refer to FIGS. 8 to 10. In step S200, a plurality of parallel separation trenches S that are spaced apart and extend along a first direction X are formed within the substrate 1 to obtain a plurality of intermediate structures 10a.

In some embodiments, step S200, which involves forming the plurality of parallel separation trenches S that are spaced apart and extend along the first direction within the substrate 1 to obtain the plurality of intermediate structures 10a, may be specifically represented as the following steps S210 to S230.

In step S210, as shown in FIGS. 8(a) and 8(b), the substrate 1 is patterned to form a plurality of parallel initial structures 10b that are spaced apart and extend along a second direction Y.

In step S220, as shown in FIGS. 8(a) and 8(b), a first sub-isolation structure 10c is formed in the gap between adjacent initial structures 10b.

In step S230, as shown in FIGS. 9 to 10, a plurality of separation trenches S along the first direction are formed within the plurality of initial structures 10b and the first sub-isolation structures to obtain the intermediate structures 10a.

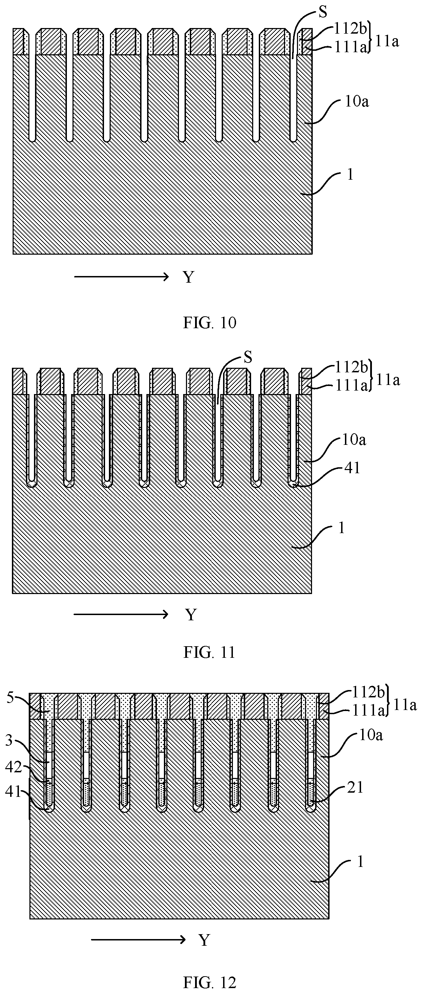

The present disclosure does not specifically limit the method for forming a plurality of separation trenches S in step S230. As an example, FIG. 10 illustrates a process structure diagram of forming a plurality of separation trenches S in some embodiments. The separation trenches S may be formed in the initial structures 10b and the first sub-isolation structures using the following method.

A patterned mask layer 11a is formed on the substrate 1; based on the patterned mask layer 11a, a plurality of separation trenches S along the first direction are formed.

The present disclosure does not specifically limit the form of the patterned mask layer 11a in the aforementioned steps. For example, the patterned mask layer 11a may be a single film layer or may include a plurality of film layers; when the patterned mask layer 11a includes a plurality of film layers, the plurality of film layers may be stacked longitudinally or arranged transversely. As an example, as shown in FIG. 10, the patterned mask layer 11a may include a mask pattern 111a and a mask sidewall 112b located on the sidewall of the mask pattern 111a. The material of the mask sidewall 112b is the same as or different from the material of the mask pattern 111a, both are permissible.

Refer to FIG. 11. In some embodiments, the manufacturing method may further include the following step.

A first interlayer dielectric layer 41 covering the inner wall of the separation trench S is formed.

Refer to FIG. 12. In step S300, a first word line 21 is formed within the separation trench S.

It should be noted that in some embodiments, step S300 is executed after forming the first interlayer dielectric layer 41 covering the inner wall of the separation trench S. Moreover, as shown in FIG. 12, the first word line 21 should be formed on the first interlayer dielectric layer 41 and fill a portion of the separation trench S.

Continue to refer to FIG. 12. In some embodiments, the manufacturing method may further include the following step.

A second interlayer dielectric layer 42 covering at least the top surface of the first word line 21 is formed. An air gap structure 3 is formed on the second interlayer dielectric layer 42.

It should be noted that in some embodiments, there may be no first interlayer dielectric layer 41 disposed between the air gap structure 3 and the inner wall of the separation trench S; that is, the first interlayer dielectric layer 41 covers the entire inner wall of the separation trench S or only a portion of the inner wall of the separation trench S, both are permissible. For example, the orthographic projection of the first interlayer dielectric layer 41 on the semiconductor pillar 100 along the second direction Y may overlap or substantially overlap with the orthographic projection of the first word line 21 on the semiconductor pillar 100.

Continue to refer to FIG. 12. In some embodiments, the manufacturing method may further include the following step.

A first isolation structure 5 is formed in the separation trench S. Specifically, the first isolation structure 5 may be used to define the top surface of the air gap structure 3, and the air gap structure 3 is located above the first word line 21 within the separation trench S.

It should be noted that in some embodiments, the step of forming the first isolation structure 5 is executed after forming the second interlayer dielectric layer 42.

Refer to FIGS. 12 to 13. In step S400, the intermediate structures 10a are patterned to obtain a plurality of active groups arranged in an array along the first direction and the second direction. Specifically, each active group includes two semiconductor pillars 100 that are opposite to each other in the second direction and separated by a separation trench S. For example, the mask pattern 111a can be removed, and then the intermediate structure 10a can be etched using the mask sidewall 112b and the portion of the first isolation structure 5 above the intermediate structure 10a as a mask, to form a plurality of active groups separated by a plurality of trenches arranged in the second direction Y.

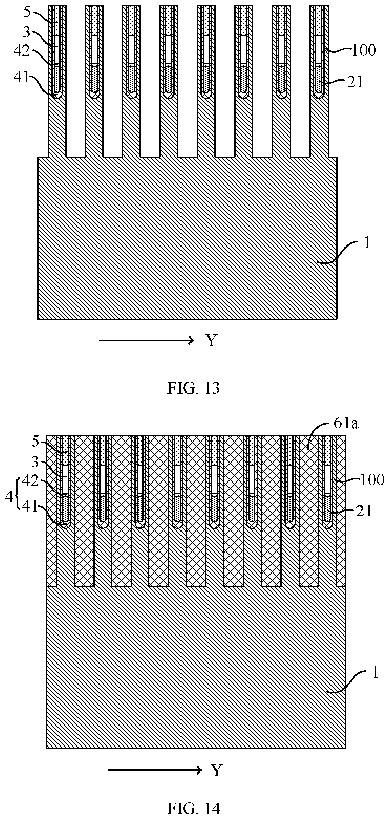

Continue to refer to FIG. 13. In some embodiments, before patterning the intermediate structures 10a in step S400, the manufacturing method may further include the following step: removing the patterned mask layer 11a and the portion of the first isolation structure 5 above the intermediate structure 10a.

The present disclosure does not specifically limit the method for removing the patterned mask layer 11a and the portion of the first isolation structure 5. As an example, the patterned mask layer 11a and the first isolation structure 5 above the intermediate structure 10a can be removed using, but not limited to, the chemical-mechanical polishing (CMP) process.

Refer to FIGS. 14 to 15. In some embodiments, after patterning the intermediate structures 10a in step S400, the manufacturing method may further include the following steps.

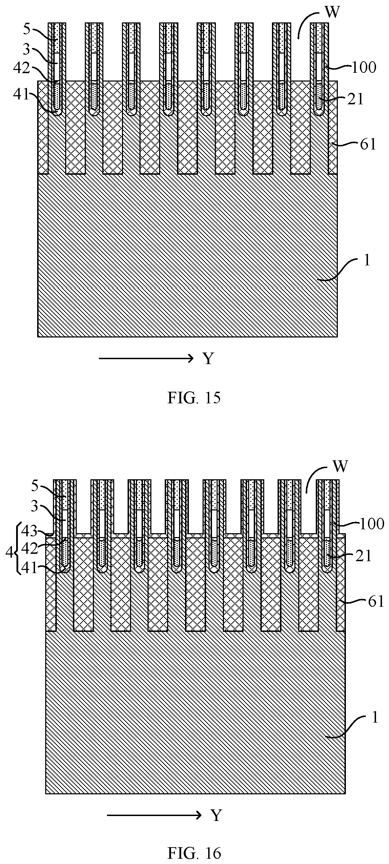

As shown in FIG. 14, an initial second sub-isolation structure 61a is formed in the gap between adjacent active groups in the second direction; as shown in FIG. 15, the initial second sub-isolation structure 61a is etched back to form a word line trench W and obtain a second sub-isolation structure 61.

The present disclosure does not specifically limit the position of the word line trench W. As an example, the bottom surface of the word line trench W may be flush with the top surface of the first word line 21; alternatively, the bottom surface of the word line trench W may be lower than the top surface of the first word line 21; alternatively, the bottom surface of the word line trench W may be higher than the top surface of the first word line 21.

Refer to FIGS. 16 to 19. In step S500, second word lines 22 are formed on the sidewalls, facing away from the separation trenches S, of the semiconductor pillars 100.

Both the second word line 22 and the first word line 21 extend along the first direction, and the second word line 22 and the first word line 21 are offset in the direction perpendicular to the substrate 1. As an example, the second word lines 22 may also be opposite to the air gap structure 3 in the second direction.

It should be noted that in some embodiments, step S500 is executed after obtaining the second sub-isolation structure.

The present disclosure does not specifically limit the position of the second word line 22. As an example, the bottom surface of the second word line 22 may be flush with the bottom surface of the air gap structure 3; alternatively, the bottom surface of the second word line 22 may be higher than the bottom surface of the air gap structure 3. As an example, the top surface of the second word line 22 may be flush with the top surface of the air gap structure 3; alternatively, the top surface of the second word line 22 may be lower than the top surface of the air gap structure 3.

In some embodiments, step S500, which involves forming the second word lines 22 on the sidewalls, facing away from the separation trenches S, of the semiconductor pillars 100, may be specifically represented as the following steps S510 to S530.

In step S510, as shown in FIG. 16, a third interlayer dielectric layer 43 is conformally formed on the inner wall of the word line trench W.

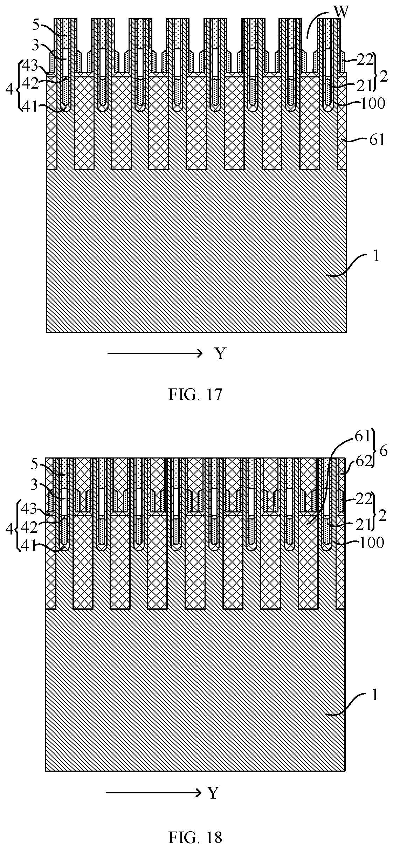

In step S520, as shown in FIG. 17, second word lines 22 are formed on the sidewalls, facing away from the semiconductor pillars 100 on both sides, of the third interlayer dielectric layer 43, respectively. There is a space between the two second word lines 22 within the same word line trench W.

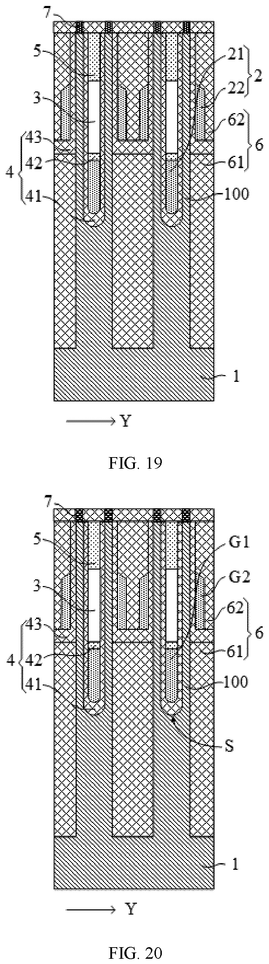

In step S530, as shown in FIGS. 18 and 19, a third sub-isolation structure 62 covering the exposed surfaces of the second sub-isolation structure 61, the second word line 22, and the third interlayer dielectric layer 43 is formed within the word line trench W. The third sub-isolation structure 62, along with the second sub-isolation structure 61 and the first sub-isolation structure, jointly form a second isolation structure 6.

The present disclosure does not specifically limit the method for forming a third interlayer dielectric layer 43 in step S510. As an example, the third interlayer dielectric layer 43 can be formed using, but not limited to, the in-situ steam generation (ISSG) process and/or atomic layer deposition (ALD) process. The present disclosure also does not specifically limit the material of the third interlayer dielectric layer 43 formed in step S510. As an example, the material of the third interlayer dielectric layer 43 may include, but is not limited to, oxides.

The present disclosure also does not specifically limit the method for forming the second word line 22 in step S520. As an example, the second word line can be formed by using, but not limited to, the physical vapor deposition (PVD) process or evaporation process to form a metal material on the sidewalls, facing away from the semiconductor pillars 100 on both sides, of the third interlayer dielectric layer 43, and then performing vertical anisotropic etching to remove the horizontal portion and part of the vertical portion of the metal material, with the remaining metal material serving as the second word line 22.

In some embodiments, the manufacturing method may further include the following step: forming a capacitor unit above the semiconductor pillar 100.

It should be noted that the methods for manufacturing a semiconductor structure provided in the present disclosure can all be used to manufacture the corresponding semiconductor structures. Therefore, the technical features between the embodiments of the method for manufacturing a semiconductor structure and the embodiments of the semiconductor structures can be interchanged and supplemented without conflict, allowing those skilled in the art to learn the technical content of the present disclosure.

The present disclosure, according to some embodiments, provides a transistor structure.

Refer to FIG. 20. In some embodiments, the transistor structure may include a semiconductor pillar 100 as well as a first gate G1 and a second gate G2 located on opposite sides of the semiconductor pillar 100, respectively.

The first gate G1 and the second gate G2 are offset in the extending direction of the semiconductor pillar 100; the first gate G1 and the second gate G2 can jointly form a control gate of the semiconductor pillar 100. For example, the bottom surface of the second gate G2 is flush with or higher than the top surface of the first gate G1, and the distance between the bottom surface of the second gate G2 and the top surface of the first gate G1 is less than 30 nm.

In the transistor structure provided in the above embodiments, the first gate G1 and the second gate G2 are offset in the direction perpendicular to the substrate 1, allowing the first gate G1 and the second gate G2 to jointly form the control gate of the corresponding semiconductor pillar 100. That is, applying a voltage only to the first gate G1 or the second gate G2 is not sufficient to turn on the corresponding transistor structure. In this way, interference with adjacent transistors can be avoided, reducing static leakage during the use of the device.

In addition, the transistor structure provided in the above embodiments avoids interference with adjacent transistors and can also reduce the parasitic capacitance between adjacent first gates G1 or adjacent second gates G2, thereby reducing the impact of the parasitic capacitance on the charging and discharging speed of the device, and thus improving the storage speed of the transistor structure.

Moreover, the offset manner of the first gate G1 and the second gate G2 in the extending direction of the semiconductor pillar 100 can, on one hand, minimize the size of the transistor structure to the greatest extent and, on the other hand, make the layout of the transistor structure more reasonable, thereby effectively enhancing the storage density of the transistor structure. For transistors with the same channel length, the first gate G1 and the second gate G2 have a shorter gate length compared to an overall gate, which can reduce the difficulty of the gate fabrication process.

In the transistor structure provided in the above embodiments, the first gate G1 may be shared by the transistor structures located on the opposite sides thereof.

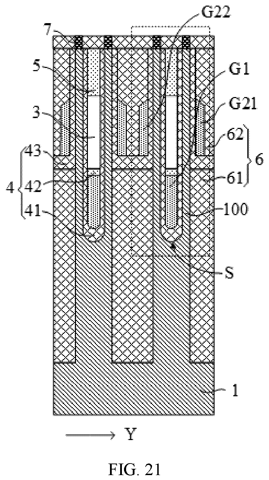

For example, the dashed box in FIG. 21 illustrates two transistor structures. When a voltage is applied to the second gate on the left side G22 and the first gate G1, the transistor structure on the left side within the dashed box in FIG. 21 is turned on, and at this point, the transistor structure on the right side within the dashed box in FIG. 21 remains in an off state; when a voltage is applied to the second gate on the right side G21 and the first gate G1, the transistor structure on the right side within the dashed box in FIG. 21 is turned on, and at this point, the transistor structure on the left side within the dashed box in FIG. 21 remains in an off state. In addition, when neither the second gate on the left side G22 nor the second gate on the right side G21 is applied with a voltage, even if other nearby transistor structures are turned on, causing the voltage of the second gate on the left side G22 or the second gate on the right side G21 to be pulled high, the first gate G1 will not be interfered with and thus can still accurately control the corresponding transistor structure through the voltage at the first gate G1 end.

The present disclosure does not specifically limit the positional relationship between the first gate G1 and the second gate G2. As an example, the top surface of the first gate G1 may be flush with the bottom surface of the second gate G2; alternatively, the top surface of the first gate G1 may be lower than the bottom surface of the second gate G2.

Continue to refer to FIG. 20. In some embodiments, the transistor structure may further include an air gap structure 3 located between two adjacent semiconductor pillars 100 and above the first gate G1.

It should be noted that in some embodiments, the bottoms of the two adjacent semiconductor pillars 100 may be interconnected.

The technical features of the above embodiments can be combined in any manner. For the sake of brevity, not all possible combinations of the technical features of the above embodiments are described. However, as long as there is no contradiction in the combination of these technical features, they should all be considered within the scope of the present disclosure.

The above embodiments merely express several implementations of the present disclosure. The descriptions are relatively specific and detailed, but they should not be construed as limiting the scope of the patent application. It should be noted that for those of ordinary skill in the art, several modifications and improvements can be made without departing from the spirit of the present disclosure, and these should fall within the protection scope of the present disclosure. Therefore, the protection scope of the present disclosed patent should be defined by the appended claims.

## Claims

1. A semiconductor structure, comprising:
a substrate (1), provided with a plurality of active groups that are spaced apart and arranged in an array along a first direction (X) and a second direction (Y), wherein each one of the plurality of active groups comprises two semiconductor pillars (100) that are opposite to each other in the second direction (Y) and separated by a separation trench (S); the second direction (Y) intersects with the first direction (X); and
a word line structure (2), the word line structure (2) comprising one first word line (21) and two second word lines (22), which are disposed corresponding to any one column of the active groups arranged along the first direction (X) of the plurality of active groups, wherein the first word line (21) is located within the separation trench (S), and the two second word lines (22) are respectively located on sidewalls, facing away from the separation trench (S), of corresponding semiconductor pillars (100),
wherein both the two second word lines (22) and the first word line (21) extend along the first direction (X), and the two second word lines (22) and the first word line (21) are offset in a direction perpendicular to the substrate (1).

2. The semiconductor structure according to claim 1, further comprising:
an air gap structure (3), located within the separation trench (S) and above the first word line (21), the air gap structure being opposite to the two second word lines (22) in the second direction (Y).

3. The semiconductor structure according to any one of claims 1 to 2, wherein a top surface of the first word line (21) is flush with a bottom surface of each one of the two second word lines (22) or lower than the bottom surface of each one of the two second word lines (22).

4. The semiconductor structure according to claim 2, wherein a bottom surface of each one of the two second word lines (22) is flush with a bottom surface of the air gap structure (3) or higher than the bottom surface of the air gap structure (3); a top surface of each one of the two second word lines (22) is flush with a top surface of the air gap structure (3) or lower than the top surface of the air gap structure (3).

5. The semiconductor structure according to claim 2, further comprising:
an interlayer dielectric layer (4), covering sidewalls, perpendicular to the second direction (Y), of the two semiconductor pillars (100) and located between the two semiconductor pillars (100) and the first word line (21) as well as between the two semiconductor pillars (100) and the two second word lines (22).

6. The semiconductor structure according to claim 5, further comprising:
a first isolation structure (5), located within the separation trench (S) and enclosing the air gap structure (3), wherein the first isolation structure (5) is used to define a top surface of the air gap structure (3); and
a second isolation structure (6), located within a gap between two of the plurality of active groups adjacent to each other and covering the two second word lines (22) and the interlayer dielectric layer (4) within the gap.

7. The semiconductor structure according to any one of claims 1 to 6, further comprising:
a plurality of capacitor contact structures (7), each one of the plurality of capacitor contact structures being disposed above a corresponding one of the two semiconductor pillars (100).

8. The semiconductor structure according to claim 3, wherein a distance between the bottom surface of each one of the two second word lines (22) and the top surface of the first word line (21) is less than 30 nm.

9. A method for manufacturing a semiconductor structure, comprising:
providing a substrate (1);
forming a plurality of parallel separation trenches (S) that are spaced apart and extend along a first direction (X) within the substrate (1) to obtain a plurality of intermediate structures (10a);
forming a first word line (21) within each one of the plurality of separation trenches (S);
patterning the plurality of intermediate structures (10a) to obtain a plurality of active groups arranged in an array along the first direction (X) and a second direction (Y), wherein each one of the plurality of active groups comprises two semiconductor pillars (100) that are opposite to each other in the second direction (Y) and separated by one of the plurality of separation trenches (S); the second direction (Y) intersects with the first direction (X); and
forming second word lines (22) on sidewalls, facing away from the plurality of separation trenches (S), of semiconductor pillars (100),
wherein both the second word line (22) and the first word line (21) extend along the first direction (X), and the second word line (22) and the first word line (21) are offset in a direction perpendicular to the substrate (1).

10. The method for manufacturing a semiconductor structure according to claim 9, wherein before patterning the plurality of intermediate structures (10a), the method further comprises:
forming a first isolation structure (5) within each one of the plurality of separation trenches (S), wherein the first isolation structure (5) is used to define a top surface of an air gap structure (3), and the air gap structure (3) is located above the first word line (21) within each one of the plurality of separation trenches (S),
wherein the second word lines (22) are opposite to the air gap structure (3) in the second direction (Y).

11. The method for manufacturing a semiconductor structure according to claim 10, wherein
before forming the first word line (21) within each one of the plurality of separation trenches (S), the method further comprises: forming a first interlayer dielectric layer (41) covering an inner wall of each one of the plurality of separation trenches (S), wherein the first word line (21) is formed on the first interlayer dielectric layer (41) and fills a portion of each one of the plurality of separation trenches (S); and
before forming the first isolation structure (5) within each one of the plurality of separation trenches (S), the method further comprises: forming a second interlayer dielectric layer (42) covering at least a top surface of the first word line (21), wherein the air gap structure (3) is formed on the second interlayer dielectric layer (42).

12. The method for manufacturing a semiconductor structure according to claim 10, wherein forming the plurality of parallel separation trenches (S) that are spaced apart and extend along the first direction (X) within the substrate (1) to obtain the plurality of intermediate structures (10a) comprises:
patterning the substrate (1) to form a plurality of parallel initial structures (10b) that are spaced apart and extend along the second direction (Y);
forming a first sub-isolation structure (10c) in a gap between two of the plurality of initial structures (10b) adjacent to each other; and
forming the plurality of separation trenches (S) along the first direction (X) within the plurality of initial structures (10b) and the first sub-isolation structures (10c) to obtain the plurality of intermediate structures (10a).

13. The method for manufacturing a semiconductor structure according to claim 12, wherein
after patterning the plurality of intermediate structures (10a) and before forming the second word lines (22) on the sidewalls, facing away from the plurality of separation trenches (S), of the semiconductor pillars (100), the method further comprises:
forming an initial second sub-isolation structure (61a) in a gap between two of the plurality of active groups adjacent to each other in the second direction (Y); and
etching back the initial second sub-isolation structure (61a) to form a word line trench (W) and obtain a second sub-isolation structure (61); and
forming the second word lines (22) on the sidewalls, facing away from the plurality of separation trenches (S), of the semiconductor pillars (100) comprises:
conformally forming a third interlayer dielectric layer (43) on an inner wall of the word line trench (W);
forming the second word lines (22) on sidewalls, facing away from semiconductor pillars (100) on both sides, of the third interlayer dielectric layer (43), respectively, wherein there is a space between two second word lines (22) within the same word line trench (W); and
forming a third sub-isolation structure (62) covering exposed surfaces of the second sub-isolation structure (61), the second word line (22), and the third interlayer dielectric layer (43) within the word line trench (W), wherein the third sub-isolation structure (62), along with the second sub-isolation structure (61) and the first sub-isolation structure (10c), jointly form a second isolation structure (6).

14. The method for manufacturing a semiconductor structure according to claim 13, wherein
a bottom surface of the word line trench (W) is flush with a top surface of the first word line (21);
or, the bottom surface of the word line trench (W) is lower than the top surface of the first word line (21).

15. The method for manufacturing a semiconductor structure according to claim 13, wherein a bottom surface of the second word line (22) is flush with a bottom surface of the air gap structure (3) or higher than the bottom surface of the air gap structure (3); a top surface of the second word line (22) is flush with a top surface of the air gap structure (3) or lower than the top surface of the air gap structure (3).

16. The method for manufacturing a semiconductor structure according to any one of claims 9 to 15, further comprising:
forming a capacitor contact structure (7) above each one of the two semiconductor pillars (100).

17. A transistor structure, comprising: a semiconductor pillar (100) as well as a first gate (G1) and a second gate (G2) located on opposite sides of the semiconductor pillar (100), respectively,
wherein the first gate (G1) and the second gate (G2) are offset in an extending direction of the semiconductor pillar (100); the first gate (G1) and the second gate (G2) jointly form a control gate of the semiconductor pillar (100).

18. The transistor structure according to claim 17, wherein a top surface of the first gate (G1) is flush with a bottom surface of the second gate (G2) or lower than the bottom surface of the second gate (G2).

19. The transistor structure according to claim 17, further comprising: an air gap structure (3) located between two said semiconductor pillars (100) adjacent to each other and above the first gate (G1), with bottoms of the two adjacent semiconductor pillars (100) interconnected.

20. The transistor structure according to any one of claims 17 to 19, wherein a distance between the bottom surface of the second gate (G2) and the top surface of the first gate (G1) is less than 30 nm.
